Europäisches Patentamt

European Patent Office

Office européen des brevets

(11) Publication number: **0 195 612**
**A2**

## (12) EUROPEAN PATENT APPLICATION

(21) Application number: **86301852.9**

(22) Date of filing: **14.03.86**

(51) Int. Cl.⁴: **H 05 K 3/24**

(30) Priority: **16.03.85 GB 8506897**

(43) Date of publication of application:
**24.09.86 Bulletin 86/39**

(84) Designated Contracting States:
**AT BE CH DE FR IT LI LU NL SE**

(71) Applicant: **MARCONI ELECTRONIC DEVICES LIMITED**
**The Grove Warren Lane**
**Stanmore Middlesex HA7 4LY(GB)**

(72) Inventor: **Pilcher, Heather**
**Shumack Hankerton Road Upper Minety**
**Nr. Swindon Wiltshire(GB)**

(74) Representative: **Hoste, Colin Francis et al,**
**The General Electric Company p.l.c. Central Patent**
**Department (Chelmsford Office) Marconi Research**
**Centre West Hanningfield Road**
**Great Baddow Chelmsford CM2 8HN, Essex(GB)**

(54) Printed circuit arrangement.

(57) A circuit arrangement is formed by producing a pattern of a conductive polymer ink upon a moulded plastics substrate. When cured the ink is treated with a palladium compound to promote the electroless deposition of copper or nickel on to the ink. Solder can then be applied to the circuit without damaging the ink.

Croydon Printing Company Ltd.

TITLE MODIFIED
see front page

I/7033/MEDL

0195612

CIRCUIT ARRANGEMENTS

This invention relates to circuit arrangements and is particularly concerned with such circuits in which conductive tracks are laid down as an electrical ink upon an insulating substrate. Such circuits are sometimes called hybrid circuits. It has been customary to utilise electrical inks which are applied as a fluid and passed through a fine mesh on to the surface of a refractory substrate such as alumina, which can withstand very high temperatures, typically 850°C at which it is necessary to fire the inks which have been used – these are termed cermet inks. The use of electrical inks which can be cured at much lower temperatures, e.g. of the order of 150°C are much to be preferred since this does not require the substrate to be of a refractory material. Instead, alternative, more easily handled materials such as thermo-setting plastics can be used. However, it has been found that the low-temperature polymer inks are not suitable for accepting a solder coating which is very desirable if electronic components are to be attached to the conductive tracks formed of the electrically conductive inks in the usual manner, and this severe disadvantage inhibits the widespread adoption of the low-temperature processing techniques. This invention seeks to provide an improved printed circuit in which this disadvantage is greatly reduced.

According to a first aspect of this invention, a method of forming a circuit upon an insulating substrate includes the steps of producing a pattern of conductive polymer ink on the substrate and curing it; coating the polymer ink with a catalytic activator; and forming an electroless plating on the activated regions.

Ink is traditionally used to describe the fluid which forms the circuit (which is generally termed a printed circuit), and in essence it embraces any liquid which is settable and which is suitable for this purpose. Generally, the ink comprises a liquid carrying a suspension of particles whose electricl properties determine the electrical characteristics of the ink when cured.

The resulting plated surface, which consists preferably of a metal such as nickel or copper, will receive solder without damaging or destroying the underlying polymer ink when the solder is heated to the temperature at which it flows. In the absence of the plating it is found that the application of hot solder directly to the ink causes the removal of the ink from the substrate; it is likely that the heat and the solder leach the conductive particles, usually silver, from the body of the ink, and because of this it has not proved possible to attach electrical components directly to polymer ink circuits using the conventional soldering techniques. The presence of the plating also acts to inhibit migration of the conductive particles, usually silver, from the ink, and therefore greatly enhances the lifetime of the circuits, and renders them more resistant to the effects of adverse environments. The invention overcomes this difficulty in a very satisfactory manner and enables the low-temperature inks to be used for many applications.

An activator which works well is a palladium compound, known as MacDermid Macuplex Accelerator D45. The use of the activator permits a metallic coating to be deposited on to the electrical ink by means of an electroless plating technique. In the absence of the activator, electroless plating does not proceed and it is therefore believed that the function of the activator is to modify the electrochemical potential of the ink surface to one in which electroless plating takes place without the need to make any metallic contact to the individual regions of the electrical ink, and the activator can therefore be regarded as a catalyst for the plating process. Accordingly, activators having a similar electrochemical effect may well be satisfactory in use. A suitable material which can be electrolessly deposited on to the activated electrical ink is nickel. It is not necessary to deposit a very great thickness of nickel and typically its thickness is very much less than that of the electrical ink which it overlies. In normal operation, the bulk of the electrical current is conducted by the electrical ink, and the electrolessly plated metal serves primarily as a barrier to protect the electrical ink when hot solder is applied to the outer surface. The presence of the activator does not impair the electrical performance of the printed circuit so formed.

According to a second aspect of this invention, a circuit arrangement includes an insulating substrate; a pattern of conductive polymer ink on the substrate; a coating of a catalytic activator overlying the polymer ink; and a layer of conductive metal formed over the activator by electroless plating.

Preferably the substrate is a thermo-setting plastics material. Such a material can be moulded into any convenient shape and forms a very suitable surface upon which to form electrical circuits by means of a screen printing process. In order to enhance the adherence of the electrical ink to the plastics material the surface of the substrate may be roughened in a manner which is as described in our co-pending patent application (ref.I/7031/MEDL).

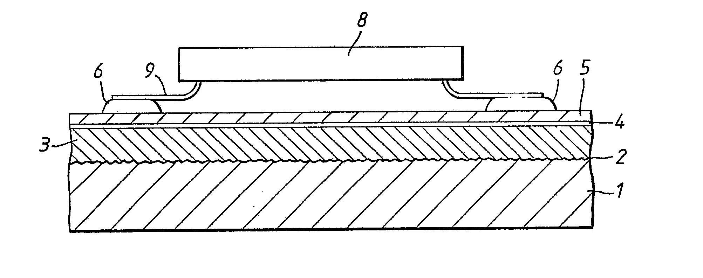

The invention is further described by way of example with reference to the accompanying drawing which shows a sectional view through part of a printed circuit.

Referring to the drawing, a substrate 1 consists of a relatively thick portion of a thermo-plastics material. Typically, a thermo-setting material such as polysulfone which is available in granular form, is used. To manufacture the substrate in a required shape, the granules are injected into a suitable mould and subjected to elevated temperature and pressure. Typically the mould temperature required is of the order of $95^{\circ}C$, the material temperature is about $395^{\circ}C$, and the pressure is 1380 Bar.

Preferably the upper surface of the plastics substrate 1 is provided with a roughened region 2 to improve the adherence of the electrically conductive polymer ink 3 which is printed upon it. The polymer ink is screen-printed in the conventional manner so as to define a required pattern of conductive pads, and tracks. Additionally, polymer inks having differing resistivities and dielectric properties can be laid down to form circuit components with different electrical properties as required. The thickness of the polymer ink is made sufficiently great so as to be capable of handling the current required by the circuit - the contribution to the current handling capability provided by the plated metal can be small.

The surface of the plastic and the ink is then subsequently cleaned thoroughly using a de-greasant. Then, a thin layer of an activator, which in this instance is the palladium compound mentioned previously, is applied by dipping the substrate into a liquid bath of it for at least half an hour, at room temperature. During this time, the activator is adsorbed into the surface of the ink. Subsequently, the substrate is removed and washed in water. Without allowing the surface of the activator to dry, the substrate is placed in an electroless plating solution and electroless plating then commences in the conventional manner. It is believed that the action of the palladium compound modifies the electrochemical potential of the ink. A standard copper or nickel electroless plating solution can be used. Typically, the electroless plating process proceeds at about a temperature of 80°C until a thickness of about 3 thousandths of an inch has been built up in the case of nickel.

It is found that the electroless plating metal adheres well to those regions of the plastic substrate which carry the electrical ink upon it. However, the plating metal does not take to the uncoated regions of the plastic substrate even though they are treated with the activator so that the metal is built up only over those regions of the substrate carrying the cured ink and at which the conductive areas are required. This is a very important aspect of the invention. It is found that solder can subsequently be applied to this plated coating even though the coating is itself extremely thin. Although the reason for this is not entirely understood, it is suggested that the plated metal acts as a barrrier to prevent leaching of the conductive particles from the electrical inks. The plating also acts to inhibit migration of the silver usually present in the ink — in the absence of the inhibiting effect the silver particles can spread (very slowly) and eventually be the cause of undesired electrical short circuits.

As is shown in the drawing, a component 8 having leads 9 is attached to the plated metal 5 by means of solder 6. The application of hot solder to the plated metal 5 does not weaken the bond between the metal 5 and the ink 3, or between the ink 3 and the substrate 1. The bond is sufficiently good to support reasonably massive electronic components of a typical nature.

In the absence of the activator layer, which is extremely thin (so thin that measurement of its thickness is difficult, if not impracticable), the electroless plating process does not proceed. In the absence of a plated coating of metal on the polymer ink, the application of hot molten solder directly on to the ink causes great damage to the ink. Indeed, if the heat is applied for more than a few seconds, the ink leaches, destroying the conductive pad or track as the case may be. The use of the present invention therefore permits a very great improvement in the application of polymer inks, and hence the adoption of low temperature moulded substrates in the place of the previously used refractory ceramic substrates, such as alumina.

CLAIMS

1.  A method of forming a circuit upon an insulating substrate includes the steps of producing a pattern of conductive polymer ink on the substrate and curing it; coating the polymer ink with a catalytic activator; and forming an electroless plating on the activated regions.

2.  A method as claimed in claim 1 and wherein the activator is applied to the whole of the substrate surface and the ink, and is operative to modify the electrochemical potential of the polymer ink so as to promote plating thereon, whilst those regions of the substrate which do not carry the ink remain unplated.

3.  A method as claimed in claim 1 or 2 and wherein the substrate is a thermosetting plastics material.

4.  A method as claimed in claim 1, 2 or 3 and wherein the activator is a palladium compound.

5.  A method as claimed in any of the preceding claims and wherein the plating is nickel or copper.

6.  A circuit arrangement including an insulating substrate; a pattern of conductive polymer ink on the substrate; a coating of a catalytic activator overlying the polymer ink; and a layer of conductive metal formed over the activator by electroless plating.

7.  An arrangement as claimed in claim 6 and wherein the substrate is a thermosetting plastics material.

8.  An arrangement as claimed in claim 6 or 7 and wherein the thickness of the plated metal is substantially less than that of the ink which it overlies.

9.    An arrangement as claimed in claim 6, 7 or 8 and wherein the metal carries adherent solder which serves to secure an electronic component to the substrate.